# EUROPÄISCHE PATENTANMELDUNG

(11) **EP 1 160 855 A2**
(43) Veröffentlichungstag der Anmeldung: **05.12.2001**
(21) Anmeldenummer: 01110456.9
(22) Anmeldetag: 27.04.2001
(51) Int. Cl.: H01L 21/8242, H01L 27/108

(54) **Speicherzelle mit einem Grabenkondensator und Verfahren zu ihrer Herstellung**

(30) Priorität: 31.05.2000 DE 10027913
(71) Anmelder: Infineon Technologies AG, 81669 München (DE)
(72) Erfinder: Weis, Rolf, Dr., Wappingers Falls,NY 12590 (US)
(74) Vertreter: Epping Hermann & Fischer

(57) **Zusammenfassung**

Die Erfindung betrifft eine Speicherzelle (1), die einen Graben (3) aufweist, in dem ein Grabenkondensator (32) gebildet ist. Weiterhin ist in dem Graben (3) ein vertikaler Transistor oberhalb des Grabenkondensators (32) gebildet. Die Dotiergebiete (15, 16) des vertikalen Transistors sind im Substrat (2) angeordnet. Zum Anschluß der Gate-Elektrode (12) des vertikalen Transistors an eine Wortleitung ist eine dielektrische Schicht (17) mit einer Innenöffnung im Graben (3) oberhalb der Gate-Elektrode (12) angeordnet. Die dielektrische Schicht (17) ist als seitliche Randstege (18) ausgebildet, die über den Querschnitt des Grabens (3) hinausragen und somit einen Teil des Substrates (2) bedecken. Die seitlichen Randstege (18) ermöglichen eine selbstjustierte Bildung eines Isolationsgrabens (21).

## Beschreibung

Die vorliegende Erfindung betrifft eine Speicherzelle mit einem Grabenkondensator und ein Verfahren zu ihrer Herstellung. Der Grabenkondensator ist in einem Substrat angeordnet und kann z.B. in einem DRAM (dynamic random access memory) zusammen mit einem Auswahltransistor eine DRAM-Speicherzelle bilden.

Speicherbauelemente, wie z.B. DRAMs bestehen aus einem Zellenfeld und einer Ansteuerungsperipherie, wobei in dem Zellenfeld einzelne Speicherzellen angeordnet sind.

Ein DRAM-Chip enthält eine Matrix von Speicherzellen, welche in Form von Zeilen und Spalten angeordnet sind und von Wortleitungen und Bitleitungen angesteuert werden. Das Auslesen von Daten aus den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor besteht u.a. aus zwei Diffusionsgebieten, welche durch einen Kanal voneinander getrennt sind, der von einem Gate gesteuert wird. Abhängig von der Richtung des Stromflusses wird ein Diffusionsgebiet als Drain-Gebiet und das andere als Source-Gebiet bezeichnet.

Eines der Diffusionsgebiete ist mit einer Bitleitung, das andere mit einem Kondensator und das Gate mit einer Wortleitung verbunden. Durch Anlegen geeigneter Spannungen an das Gate wird der Transistor so gesteuert, daß ein Stromfluß zwischen den Diffusionsgebieten durch den Kanal ein- und ausgeschaltet wird.

Durch die fortschreitende Miniaturisierung von Speicherbauelementen wird die Integrationsdichte Schritt für Schritt erhöht. Die Erhöhung der Integrationsdichte bedeutet, daß die pro Speicherzelle zur Verfügung stehende Substratoberfläche immer weiter abnimmt.

Um die zur Verfügung stehende Fläche effektiv auszunutzen, kann der Auswahltransistor als vertikaler Transistor in einem Graben oberhalb eines Grabenkondensators gebildet werden. Eine gattungsbildende Speicherzelle mit einem Grabenkondensator und einem vertikalen Transistor ist in der Druckschrift US 5,177,576 beschrieben. Weitere Ausführungen zu Grabenkondensatoren oder Transistoren sind in den US-Patenten 5,208,657 und 5,744,386 beschrieben. Es besteht allerdings bei den genannten Varianten das Problem, daß Gate des vertikalen Transistors an eine Wortleitung anzuschließen und den Drain-Kontakt des vertikalen Transistors an eine Bitleitung anzuschließen. Bei fortschreitender Miniaturisierung werden die Anforderungen an diese beiden Anschlüsse bezüglich der Justiergenauigkeit weiter steigen. Ein zusätzliches Problem besteht bei der Bildung eines Isolationsgrabens (STI), der weder zu dicht an dem Graben des Grabenkondensators gebildet werden sollte, da in diesem Fall der vertikale Transistor, der in dem oberen Bereich des Grabens angeordnet ist, in seiner Funktion beeinträchtigt wird, noch sollte der Isolationsgraben (STI) zu weit von dem Graben des Grabenkondensators entfernt sein, da dadurch wertvolle Substratoberfläche verschwendet würde.

Es ist die Aufgabe der Erfindung, eine in Hinblick auf ihre Integrationsfähigkeit verbesserte Speicherzelle mit einem Graben zur Verwendung mit einem Transistor und ein entsprechendes Herstellungsverfahren anzugeben.

Bezüglich der Speicherzelle wird die Aufgabe gelöst durch eine Speicherzelle mit:
- einem Substrat;
- einem Graben, der einen unteren Bereich, einen oberen Bereich und eine Grabenöffnung aufweist und in dem Substrat angeordnet ist;
- einem Grabenkondensator, der in dem Graben gebildet ist;
- einer leitenden Grabenfüllung, die als Bestandteil des Grabenkondensators in dem unteren Bereich des Grabens angeordnet ist;
- einem vertikalen Auswahltransistor, der in dem oberen Bereich des Grabens angeordnet ist und ein unteres Dotiergebiet, ein oberes Dotiergebiet und eine Gate-Elektrode umfaßt, wobei
- das untere Dotiergebiet im oberen Bereich des Grabens neben dem Graben in dem Substrat angeordnet ist,
- das obere Dotiergebiet im oberen Bereich des Grabens in dem Substrat, oberhalb des unteren Dotiergebietes angeordnet ist und
- die dielektrische Schicht oberhalb des Grabens angeordnet ist und eine Innenöffnung aufweist,
- wobei sich die Innenöffnung vollständig durch die dielektrische Schicht erstreckt und die dielektrische Schicht seitlich über die Grabenöffnung hinausragt.

Dabei wird ein vertikaler Transistor durch das seitlich neben dem Graben angeordnete untere Dotiergebiet, das obere Dotiergebiet und das dazwischen liegende Kanalgebiet gebildet. Die Junction-Tiefe (üblicherweise wird bei Feldeffekttransistoren die Dicke der Source- und Drain-Gebiete als Junction-Tiefe bezeichnet) des oberen und unteren Dotiergebietes und die Dicke des Kanalgebietes werden z.B. durch den Abstand zu einem Isolationsgraben bestimmt. Durch die Anordnung der dielektrischen Schicht mit ihrer Innenöffnung wird der Graben und damit die durch die Innenöffnung freigelegte Grabenfüllung für Kontaktierungen zugänglich. Hier kann z.B. eine Gate-Elektrode des vertikalen Transistors angeschlossen werden. Durch die erfindungsgemäße Anordnung der dielektrischen Schicht, die über die Grabenöffnung hinausragt, kann die dielektrische Schicht als Ätzmaske z.B. bei der Ätzung eines Isolationsgrabens verwendet werden. Dieses Vorgehen hat den Vorteil, daß die Junction-Tiefe des vertikalen Transistors nicht durch einen Lithographieschritt definiert wird, sondern selbstjustiert zu dem Graben mit Hilfe der dielektrischen Schicht durchgeführt werden kann.

Eine weitere vorteilhafte Ausgestaltung der Erfindung sieht vor, daß die dielektrische Schicht in das Substrat eingesenkt ist. Das Einsenken der dielektrischen Schicht in das Substrat hat den Vorteil, daß eine geringe Topologie für nachfolgende Schichten auf der Substratoberfläche vorliegt. Dadurch ist die Konformität und Gleichmäßigkeit nachfolgender Schichten verbessert. Zusätzlich eignet sich eine planare Oberfläche besser für nachfolgende photolithographische Belichtungsschritte, da die Schärfentiefe in diesem Fall nur in einem kleineren Bereich umfassen muß.

Eine weitere vorteilhafte Ausgestaltung der Erfindung sieht vor, daß die dielektrische Schicht eine Oberkante aufweist und das Substrat eine Substratoberfläche aufweist und daß die Oberkante der dielektrischen Schicht mit der Substratoberfläche auf gleicher Höhe angeordnet ist. Durch die Anordnung auf gleicher Höhe wird eine Topographiestufe vermieden. Diese Anordnung kann z.B. durch einen CMP-Schritt (Chemical Mechanical Polishing) hergestellt werden.

Weiterhin ist es vorteilhaft, daß neben der dielektrischen Schicht ein Isolationsgraben angeordnet ist, der mit einem Isolator gefüllt ist. Der Isolationsgraben (STI) hat die Aufgabe, benachbarte Speicherzellen voneinander zu isolieren. Besonders vorteilhaft ist hier, daß die dielektrische Schicht als Ätzmaske für die Ätzung des Isolationsgrabens verwendet werden kann. Dadurch ist eine selbstjustierte Bildung des Isolationsgrabens möglich, wobei die Position des Isolationsgrabens nicht durch die erreichbare lithographische Genauigkeit, sondern durch die Lage der dielektrischen Schicht definiert wird.

Eine weitere vorteilhafte Ausbildung der Erfindung sieht vor, daß neben der dielektrischen Schicht in dem Substrat ein dotiertes Gebiet angeordnet ist. Das dotierte Gebiet neben der dielektrischen Schicht ist mit einer Bitleitung verbunden, die auf dem dotierten Gebiet verläuft. Zusätzlich ist das dotierte Gebiet an das obere Dotiergebiet angeschlossen. Dadurch ist eine kompakte Anordnung der Speicherzellen möglich, die einen vorteilhaft kleinen Anschlußwiderstand an die Bitleitung und eine vorteilhaft kleine Bitleitungskapazität aufweist.

Eine weitere Ausbildung der Erfindung sieht vor, daß unterhalb der dielektrischen Schicht eine Gate-Elektrode angeordnet ist. Die Gate-Elektrode hat dabei z.B. die Aufgabe, den Auswahltransistor der Speicherzelle zu steuern. Vorteilhafterweise ist die Gate-Elektrode dabei unterhalb der dielektrischen Schicht angeordnet, so daß es durch die Innenöffnung in der dielektrischen Schicht mit einer Wortleitung mittels eines Wortleitungskontaktes verbunden werden kann.

In Bezug auf das Verfahren wird die erfindungsgemäße Aufgabe gelöst durch ein Verfahren zur Herstellung einer Speicherzelle mit den Schritten:
- Bilden eines Grabens in einem Substrat, wobei eine erste Maske zur Ätzung des Grabens auf dem Substrat gebildet wird;
- Bilden eines Grabenkondensators in dem Graben;
- Bilden eines vertikalen Auswahltransistors mit einer Gate-Elektrode in dem Graben;
- Aufweiten der ersten Maske, so daß eine Aufweitung mit einem größeren Querschnitt als dem Querschnitt des Grabens freigelegt wird;
- Einsenken des Substrats und der in dem Graben angeordneten Gate-Elektrode in dem von der Aufweitung freigelegten Bereich, wobei eine Einsenkung gebildet wird;
- Bilden einer dielektrischen Schicht in der Einsenkung.

Durch das erfindungsgemäße Verfahren wird die Maske, die zur Ätzung des Grabens für den Grabenkondensator verwendet wird, aufgeweitet und zur Ätzung einer Einsenkung verwendet. Die Aufweitung der Maske hat den Vorteil, daß es sich dabei um einen selbstjustierten Prozeß handelt, der keine weiteren photolithographischen Schritte erfordert, sondern selbstjustiert um den bereits bestehenden Graben eine Einsenkung bildet.

In einem Verfahrensschritt wird Dotierstoff in die Gate-Elektrode und das Substrat in den Bereich der Einsenkung eingebracht. Durch diesen Prozeßschritt wird in vorteilhafter Weise ein oberes Dotiergebiet in dem Substrat gebildet, das als Source- bzw. Drain-Gebiet eines vertikalen Transistors verwendet und an eine Bitleitung angeschlossen werden kann.

Ein weiterer Verfahrensschritt sieht vor, daß eine dielektrische Schicht in der Einsenkung abgeschieden wird und mit einem anisotropen Ätzschritt seitliche Randstege aus der dielektrischen Schicht gebildet werden. Durch diesen Verfahrensschritt wird selbstjustiert in der Einsenkung die dielektrische Schicht gebildet, die eine Innenöffnung aufweist und damit der Form eines Torus ähnlich ist. Dies hat den Vorteil, daß ein weiterer Lithographieschritt, der Justierungenauigkeiten beinhalten würde, vermieden werden kann.

Ein weiterer Verfahrensschritt sieht vor, daß eine zweite Maske auf dem Substrat angeordnet und strukturiert wird, und daß das Substrat in einem Bereich freigelegt wird, in dem die zweite Maske strukturiert ist. Durch dieses Vorgehen wird die erste Maske in einem Bereich strukturiert, in dem anschließend ein Isolationsgraben gebildet werden kann. Dabei legt das Entfernen der ersten Maske z.B. einen Bereich der Substratoberfläche und einen Bereich der dielektrischen Schicht frei.

In einem weiteren Verfahrensschritt bilden die erste Maske, die zweite Maske und die seitlichen Randstege eine gemeinsame Ätzmaske beim Ätzen eines Isolationsgrabens. Dadurch wird der Isolationsgraben in die freigelegte Substratoberfläche geätzt, wobei nicht die Justiergenauigkeit der Photolithographie der zweiten Maske die Positioniergenauigkeit des Isolationsgrabens angibt, sondern der Isolationsgraben selbstjustiert durch die dielektrische Schicht von dem Graben des Grabenkondensators beabstandet ist, und so einen sehr genau einstellbaren Abstand zu den in das Substrat eingebrachten Diffusionsgebieten aufweist. Dies ermöglicht eine sehr genaue Einstellung der Junction-Tiefe.

Weitere Ausgestaltungen der Erfindung sind in den Unteransprüchen angegeben.

Die Erfindung wird nachfolgend an einem Ausführungsbeispiel anhand von Figuren näher erläutert. In den Figuren zeigen:
- Figur 1: einen Grabenkondensator, der als Ausgangsbasis für das erfindungsgemäße Verfahren herangezogen wird;
- Figur 2: einen Grabenkondensator, der aus dem in Figur 1 dargestellten Grabenkondensator durch einen Einsenkprozeß hervorgeht;
- Figur 3 bis 12: den oberen Bereich des Grabenkondensators aus Figur 1 mit jeweils aufeinander folgenden Herstellungsschritten zur Bildung einer erfindungsgemäßen Speicherzelle;
- Figur 13 bis 19: zwei benachbarte Speicherzellen, die sich in ihrer Herstellung an die in Figur 12 dargestellte Speicherzelle anschließen, wobei jeweils aufeinander folgende Herstellungsschritte dargestellt sind.

In den Figuren bezeichnen gleiche Bezugszeichen gleiche oder funktionsgleiche Element.

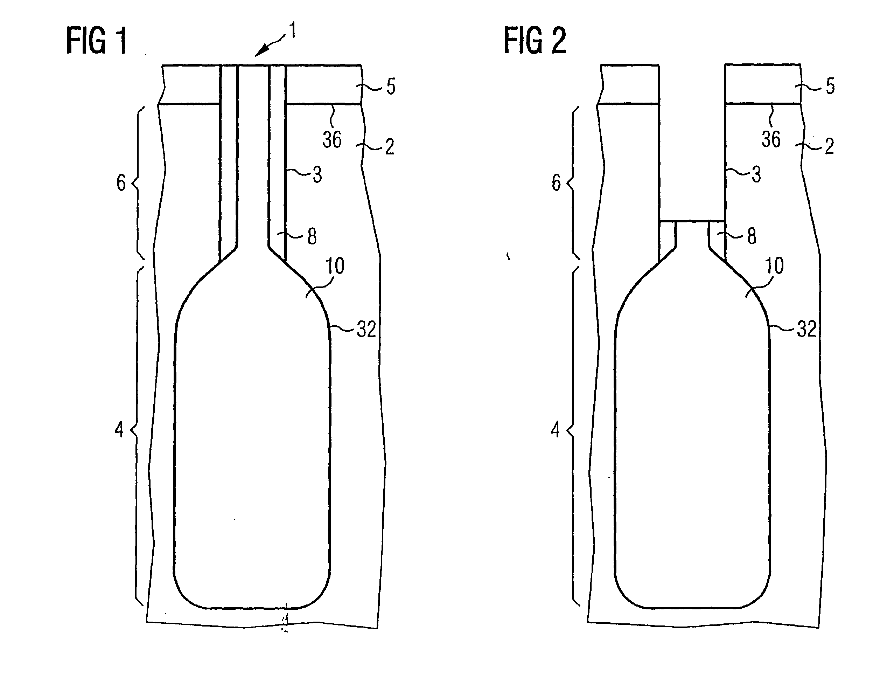

In Figur 1 ist eine Speicherzelle 1 dargestellt, die einen Graben 3 umfaßt, der in einem Substrat 2 gebildet ist. Das Substrat 2 besteht in diesem Ausführungsbeispiel aus Silizium, das mit Bor, Phosphor oder Arsen dotiert sein kann. Der Graben 3 weist einen unteren Bereich 4 und einen oberen Bereich 6 auf. In dem oberen Bereich 6 des Grabens 3 ist ein Isolationskragen 8 angeordnet. Der Isolationskragen 8 besteht üblicherweise aus Siliziumoxid. Weiterhin befindet sich auf dem Substrat 2 eine erste Maske 5, die als Ätzmaske für die Ätzung des Grabens 3 dient. Die Ätzmaske 5 ist beispielsweise aus Siliziumnitrid gebildet. In dem unteren Bereich 4 des Grabens 3, der in diesem Fall flaschenförmig (bottle-shaped) ausgebildet ist, ist an der Grabenwand ein Kondensatordielektrikum angeordnet. Üblicherweise besteht ein Kondensatordielektrikum in Grabenkondensatoren aus Siliziumoxid, Siliziumnitrid oder Siliziumoxinitrid oder einer beliebigen Kombination dieser Materialien. Zusätzlich ist der Graben 3 mit einer leitenden Grabenfüllung 10 gefüllt. Die leitende Grabenfüllung 10 besteht beispielsweise aus dotiertem Silizium. Die leitende Grabenfüllung 10 dient als innere Kondensatorelektrode, das außenliegende Substrat 2 als äußere Kondensatorelektrode.

Ein Herstellungsverfahren zur Bildung des in Figur 1 dargestellten Grabenkondensators besteht in dem Abscheiden einer ersten Maske 5 als Hartmaske auf einem Substrat 2, wobei die erste Maske 5 üblicherweise aus Siliziumnitrid gebildet wird. Zur Herstellung der ersten Maske 5 wird beispielsweise ein LPCVD-Verfahren (low pressure chemical vapour deposition) verwendet. Die erste Maske 5 wird anschließend strukturiert und als Ätzmaske für die Ätzung des Grabens 3 verwendet. Nach dem Ätzen des Grabens 3 wird dieser mit einem Kondensatordielektrikum ausgekleidet, welches z.B. durch thermische Oxidation und durch CVD-Verfahren gebildet werden kann. In einem folgenden Verfahrensschritt wird der Isolationskragen 8 in dem oberen Bereich 6 des Grabens 3 gebildet. Der Isolationskragen 8 ist aus einem Siliziumoxid gebildet, das üblicherweise mit einem CVD-Prozeß aufgebracht wird. Die leitende Grabenfüllung 10 besteht in diesem Ausführungsbeispiel aus einem hochdotierten Polysilizium und wird üblicherweise ebenfalls durch einen CVD-Prozeß in den Graben 3 abgeschieden.

Mit Bezug auf Figur 2 werden ausgehend von Figur 1 die leitende Grabenfüllung 10 und der Isolationskragen 8 eingesenkt, so daß sie aus dem oberen Bereich 6 des Grabens 3 entfernt werden.

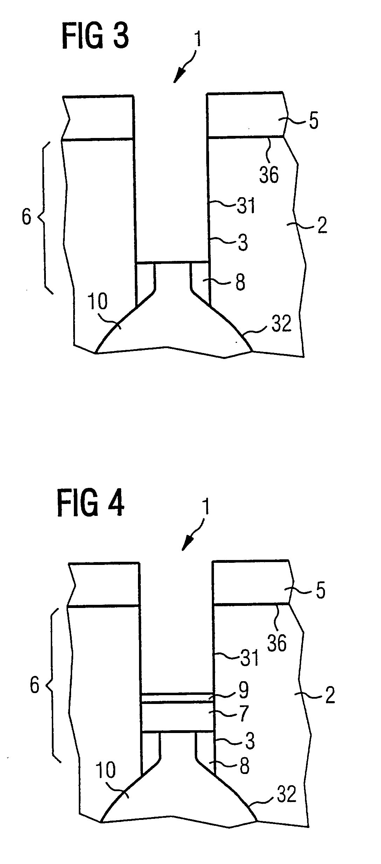

In Figur 3 wird eine Nitridierung des Substrates 2 durchgeführt, welches in dem oberen Bereich 6 des Grabens 3 freigelegt wurde. Dabei entsteht eine Nitridschicht 31, die später als Diffusionsbarriere für Dotierstoff dienen wird und elektrisch als Tunnelwiderstand funktioniert.

Weiterhin (Figur 4) wird in dem oberen Bereich 6 des Grabens 3 eine leitende Schicht 7 gebildet. Die leitende Schicht 7 besteht z.B. aus einem dotierten Polysilizium, welches in einem Herstellungsverfahren durch einen CVD-Prozeß in dem Graben abgeschieden planarisiert und anschließend eingesenkt wird, so daß die in Figur 4 gezeigte Füllhöhe erreicht wird. Auf der leitenden Schicht 7 wird in dem oberen Bereich 6 des Grabens 3 eine isolierende Deckschicht 9 angeordnet. Die isolierende Deckschicht 9 besteht beispielsweise aus Siliziumoxid und kann mit einem CVD-Prozeß abgeschieden, planarisiert und in den Graben eingesenkt werden.

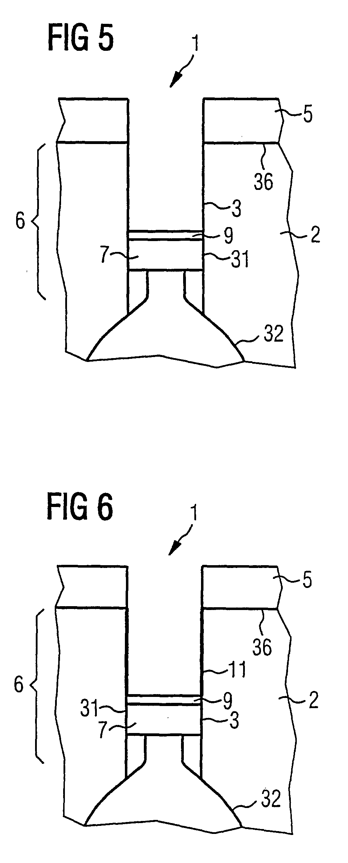

Mit Bezug auf Figur 5 wird die Nitridschicht 31 aus dem oberen Bereich 6 des Grabens 3 entfernt. Dabei bleibt die Nitridschicht 31 in dem Bereich, der von der leitenden Schicht 7 und der isolierenden Deckschicht 9 bedeckt wird, erhalten. Das Entfernen der Nitridschicht 31 kann beispielsweise mit einem nasschemischen Prozeß unter Verwendung von heißer Phosphorsäure geschehen.

In Figur 6 wird in dem oberen Bereich 6 des Grabens 3 ein Gate-Oxid 11 auf dem freigelegten Substrat 2 gebildet. Dies kann z.B. in einem thermischen Prozeßschritt mit sauerstoffhaltiger Atmosphäre durchgeführt werden.

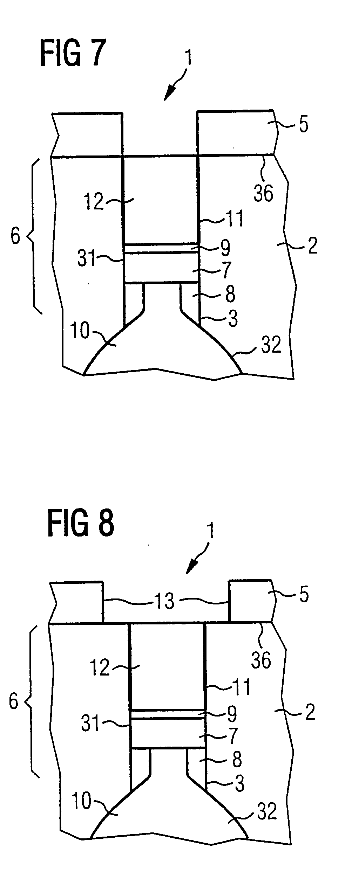

Anschließend (Figur 7) wird eine Gate-Elektrode 12 in dem oberen Bereich 6 des Grabens 3 gebildet. Dies kann beispielsweise durch eine CVD-Abscheidung von dotiertem Polysilizium durchgeführt werden. Anschließend wird die abgeschiedene Polysiliziumschicht mit einem CMP-Schritt planarisiert und bis zur Substratoberfläche in den Graben 3 eingesenkt.

Mit Bezug auf Figur 8 wird in einem Ätzprozeß die Maske 5 aufgeweitet, so daß die Aufweitung 13 oberhalb des Grabens 3 und oberhalb des Substrates 2 in der ersten Maske 5 entsteht. Da die Maske 5 beispielsweise aus Nitrid besteht, kann die Aufweitung mit einem Ätzprozeß unter Verwendung von Phosphorsäure oder HFEG (HF: Flußsäure, EG: Ethylen-Glycol), das sowohl Siliziumoxid als auch Siliziumnitrid mit etwa gleichen Ätzraten ätzt, durchgeführt werden.

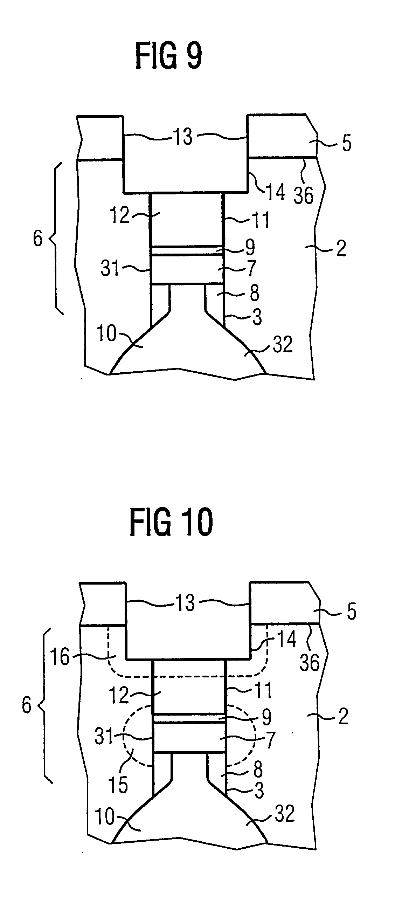

Im Zusammenhang mit Figur 9 wird ein Einsenkprozeßschritt durchgeführt, der die Aufweitung 13 in das Substrat und den Graben überträgt, wobei die Einsenkung 14 entsteht. Die Einsenkung 14 kann beispielsweise mit einem anisotropen Ätzprozeß durchgeführt werden.

In Figur 10 wird ein unteres Dotiergebiet 15 und ein oberes Dotiergebiet 16 gebildet. Das untere Dotiergebiet 15 entsteht dabei durch Ausdiffusion von Dotierstoff aus der hochdotierten leitenden Schicht 7. Das untere Dotiergebiet 15 wird später als unteres Source-Drain-Gebiet des vertikalen Transistors verwendet. Das obere Dotiergebiet 16 wird beispielsweise mittels einer Gasphasendotierung gebildet. Dabei gelangt Dotierstoff in das Substrat 2 und bildet das obere Dotiergebiet 16. Bei der Ausdiffusion des unteren Dotiergebietes 15, die üblicherweise mit einem Temperaturschritt durchgeführt wird, kann ebenfalls das obere Dotiergebiet 16 ausdiffundieren, wobei eventuelle Kristallversetzungen die durch die Dotierung entstanden sind ausgeheilt werden können. Optional kann der Temperaturschritt oxidierend ausgeführt werden.

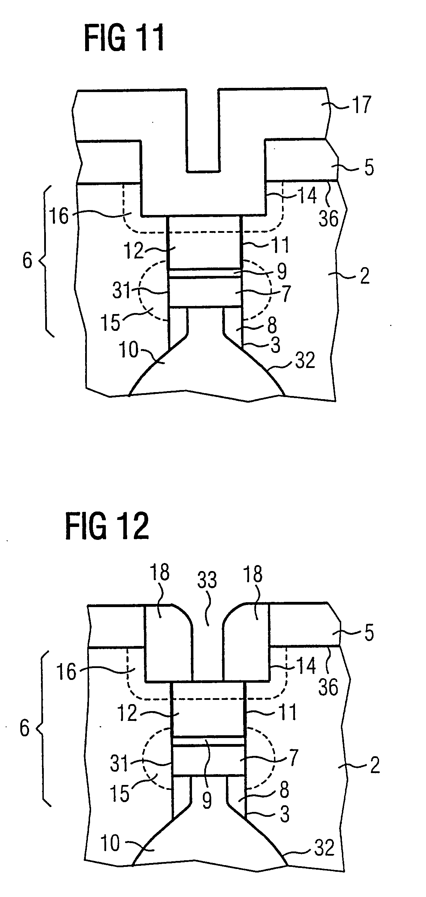

Mit Bezug auf Figur 11 wird eine dielektrische Schicht 17 auf dem Substrat und in der Einsenkung 14 abgeschieden. Die dielektrische Schicht 17 besteht beispielsweise aus Siliziumnitrid und kann mittels eines CVD-Prozesses gebildet werden.

In Zusammenhang mit Figur 12 wird ein anisotroper Ätzschritt durchgeführt, wobei die seitlichen Randstege 18 gebildet werden (Spacerbildung). Die seitlichen Randstege sind dabei in der Einsenkung 14 angeordnet und weisen eine ringförmige Struktur auf, die einem Torus ähnlich ist.

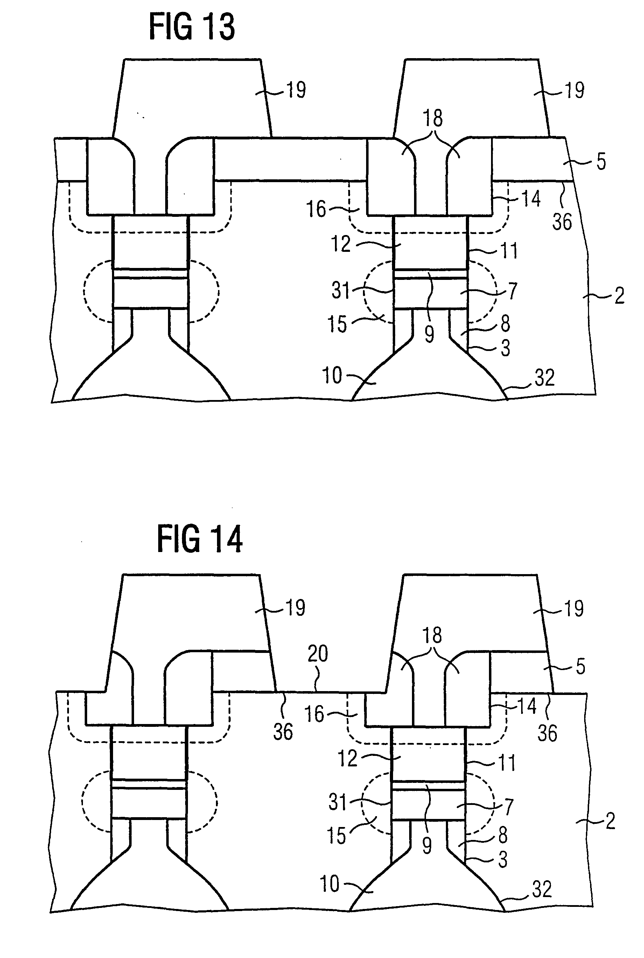

In Figur 13 sind zwei benachbarte Speicherzellen dargestellt. Zusätzlich ist eine zweite Maske 19 auf dem Substrat angeordnet und strukturiert worden. Die Maske 19 besteht beispielsweise aus einem Photolack.

Mit Bezug auf Figur 14 wird die erste Maske 5 mit Hilfe der zweiten Maske 19 strukturiert. Dazu wird beispielsweise ein anisotroper Ätzschritt verwendet. Da die erste Maske 5 und die seitlichen Randstege 18 aus Siliziumnitrid bestehen, wird sowohl die erste Maske 5 als auch die Teil des seitlichen Randsteges 18 entfernt. Bei diesem Ätzprozeß entsteht ein freigelegter Bereich 20, der die Substratoberfläche 36 freigibt.

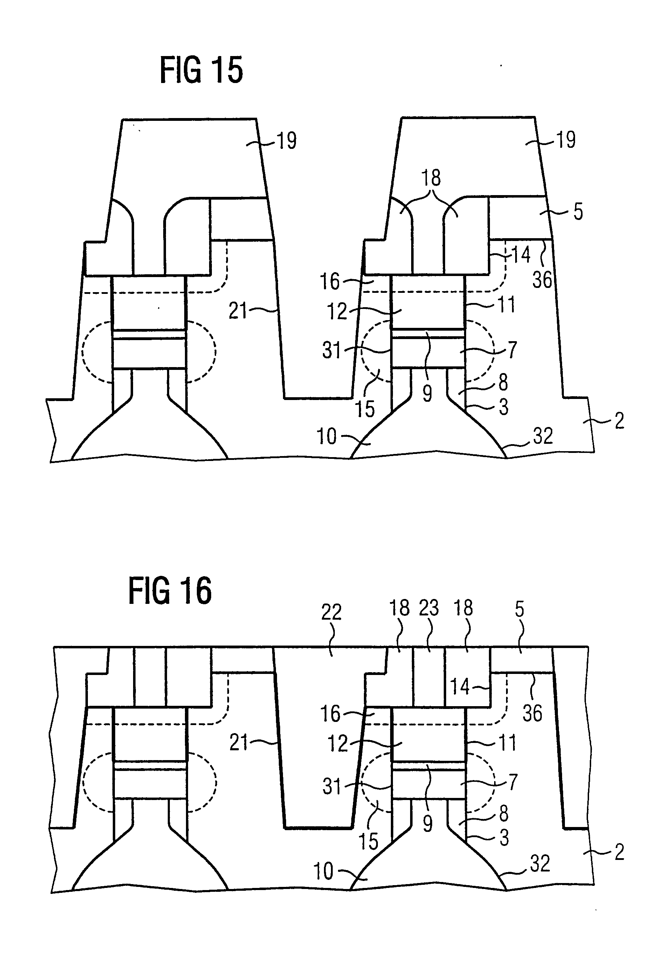

Weiterhin (Figur 15) wird der Isolationsgraben 21 in dem freigelegten Bereich 20 in das Substrat 2 geätzt. Dabei dient die erste Maske 5, die zweite Maske 19 und der seitliche Randsteg 18 als Ätzmaske. Die Ätzung kann mit Substanzen und Prozessen durchgeführt werden, die Silizium ätzen und dabei selektiv zu Siliziumnitrid und Photolack vorgehen.

Mit Bezug auf Figur 16 wird der Photolack entfernt und anschließend die Seitenwand des Isolationsgrabens 21 oxidiert und der Isolationsgraben 21 wird mit einer Isolationsgrabenfüllung 22 gefüllt. Dazu kann beispielsweise ein HDP-Prozeß (high density plasma-CVD) durchgeführt werden. Bei dem HDP-Prozeß wird ein Siliziumoxid als Isolationsgrabenfüllung 22 in den Isolationsgraben 21 gefüllt. Anschließend wird die Substratoberfläche 36 mit einem CMP-Prozeß (chemical mechanical polishing) planarisiert.

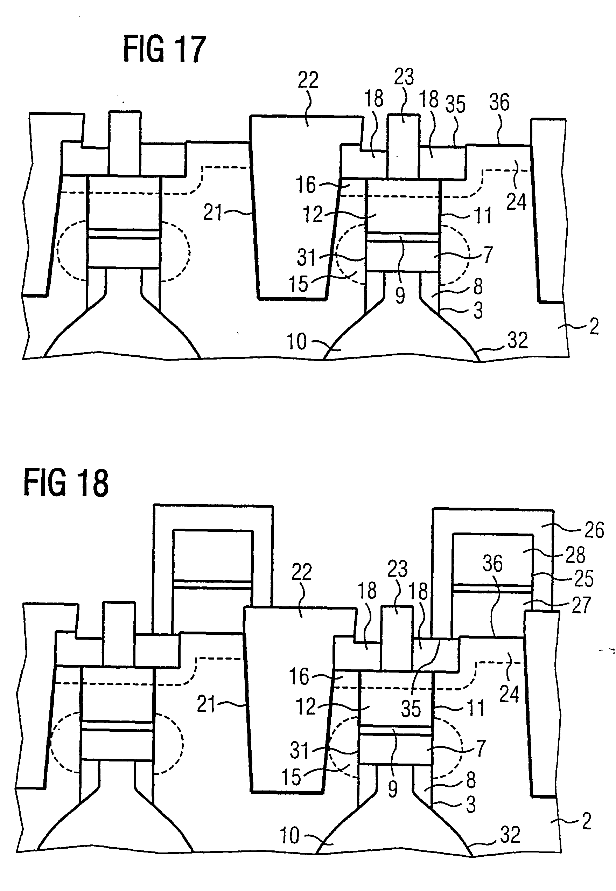

Mit Bezug auf Figur 17 wird die erste Maske 5 und ein Teil der seitlichen Randstege 18 entfernt. Da die erste Maske 5 und die seitlichen Randstege 18 aus Siliziumnitrid bestehen, können sie mit heißer Phosphorsäure geätzt werden. Dabei wird die Substratoberfläche 36 freigelegt. Anschließend wird ein Streuoxid auf der freigelegten Substratoberfläche 36 angeordnet und eine Dotierstoffimplantation durchgeführt, wobei das Bitleitungsdotiergebiet 24 in dem Substrat 2 gebildet wird. Anschließend wird das Streuoxid wieder entfernt.

In Figur 18 wird eine Bitleitung 25 auf dem Bitleitungsdotiergebiet 24 gebildet. Die Bitleitung 25 besteht in diesem Ausführungsbeispiel aus einer unteren Bitleitungsschicht 27 und einer oberen Bitleitungsschicht 28. Die untere Bitleitungsschicht besteht dabei beispielsweise aus einem hochdotierten Polysilizium, die obere Bitleitungsschicht 28 wird beispielsweise aus Wolfram gebildet, das einen geringeren Schichtwiderstand als das dotierte Polysilizium aufweist, so daß die Bitleitung insgesamt niederohmiger ausgebildet wird.

Anschließend wird eine Isolationshülle 26 um die Bitleitung 25 gebildet. Die Isolationshülle 26 besteht beispielsweise aus Siliziumnitrid.

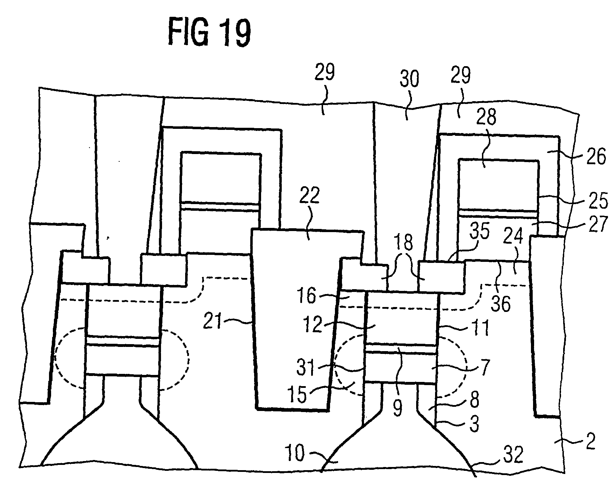

Anschließend (Figur 19) wird eine Isolationsschicht 29 auf dem Substrat angeordnet. Die Isolationsschicht 29 überdeckt dabei die Bitleitung 25 und planarisiert die Oberfläche. Die Isolationsschicht 29 besteht beispielsweise aus einem hochdotierten Silikatglas (BPSG) und wird in einem Temperaturschritt verflossen. In die Isolationsschicht 29 wird ein Graben geätzt, in dem ein Wortleitungskontakt 30 angeordnet wird. Der Wortleitungskontakt 30 erstreckt sich dabei von einer Wortleitung durch die Isolationsschicht 29 und durch die seitlichen Randstege 18 bis zu der Gate-Elektrode 12.

## Patentansprüche

1. Speicherzelle mit:
- einem Substrat (2);
- einem Graben (3), der einen unteren Bereich (4), einen oberen Bereich (6) und eine Grabenöffnung (34) aufweist und in dem Substrat (2) angeordnet ist;
- einem Grabenkondensator (32), der in dem Graben (3) gebildet ist;
- einer leitenden Grabenfüllung (10), die als Bestandteil des Grabenkondensators (32) in dem unteren Bereich (4) des Grabens (3) angeordnet ist;
- einem vertikalen Auswahltransistor, der in dem oberen Bereich (6) des Grabens (3) angeordnet ist und ein unteres Dotiergebiet (15), ein oberes Dotiergebiet (16) und eine Gate-Elektrode (12) umfaßt, wobei
- das untere Dotiergebiet (15) im oberen Bereich (6) des Grabens (3) neben dem Graben (3) in dem Substrat (2) angeordnet ist,
- das obere Dotiergebiet (16) im oberen Bereich (6) des Grabens (3) in dem Substrat (2), oberhalb des unteren Dotiergebietes (15) angeordnet ist und
- die dielektrische Schicht (17, 18) oberhalb des Grabens (3) angeordnet ist und eine Innenöffnung (33) aufweist,
**dadurch gekennzeichnet, daß**
sich die Innenöffnung (33) vollständig durch die dielektrische Schicht (17, 18) erstreckt und die dielektrische Schicht (17, 18) seitlich über die Grabenöffnung (34) hinausragt.

2. Speicherzelle nach Anspruch 1,
**dadurch gekennzeichnet, daß**
die dielektrische Schicht (17) in das Substrat (2) eingesenkt ist.

3. Speicherzelle nach Anspruch 2,
**dadurch gekennzeichnet, daß**
die dielektrische Schicht (17) eine Oberkante (35) aufweist und das Substrat (2) eine Substratoberfläche (36) aufweist, und daß die Oberkante der dielektrischen Schicht (17) mit der Substratoberfläche (36) auf gleicher Höhe angeordnet ist.

4. Speicherzelle nach einem der Ansprüche 1 bis 3,
**dadurch gekennzeichnet, daß**
ein Isolationsgraben (21) an die dielektrischen Schicht (17) angrenzt, der mit einer Isolationsgrabenfüllung (22) gefüllt ist.

5. Speicherzelle nach einem der Ansprüche 1 bis 4,
**dadurch gekennzeichnet, daß** ein dotiertes Gebiet (24) in dem Substrat (2) angeordnet ist und an die dielektrischen Schicht (17) angrenzt.

6. Speicherzelle nach einem der Ansprüche 1 bis 5,
**dadurch gekennzeichnet, daß**
unterhalb der dielektrischen Schicht (17) eine Gate-Elektrode (12) angeordnet ist.

7. Verfahren zur Herstellung einer Speicherzelle mit den Schritten:
- Bilden eines Grabens (3) in einem Substrat (2), wobei eine erste Maske (5) zur Ätzung des Grabens (3) auf dem Substrat (2) gebildet wird;
- Bilden eines Grabenkondensators (32) in dem Graben (3);
- Bilden eines vertikalen Auswahltransistors mit einer Gate-Elektrode (12) in dem Graben (3);
- Aufweiten der ersten Maske (5), so daß eine Aufweitung (13) mit einem größeren Querschnitt als dem Querschnitt des Grabens (3) freigelegt wird;
- Einsenken des Substrats (2) und der in dem Graben (3) angeordneten Gate-Elektrode (12) in dem von der Aufweitung (13) freigelegten Bereich, wobei eine Einsenkung (14) gebildet wird;
- Bilden einer dielektrischen Schicht (17, 18) in der Einsenkung (14).

8. Verfahren nach Anspruch 7,
**dadurch gekennzeichnet, daß**
Dotierstoff in dem Bereich der Einsenkung (14) in das Substrat (2) eingebracht wird und ein oberes Dotiergebiet (16) bildet.

9. Verfahren nach einem der Ansprüche 7 oder 8,
**dadurch gekennzeichnet, daß**
eine dielektrische Schicht (17) in der Einsenkung (14) abgeschieden wird und mit einem anisotropen Ätzprozeß seitliche Randstege (18) aus der dielektrischen Schicht (17) gebildet werden.

10. Verfahren nach einem der Ansprüche 7 bis 9,
**dadurch gekennzeichnet, daß**
eine zweite Maske (19) auf dem Substrat (2) angeordnet und strukturiert wird, und daß das Substrat in einem Bereich (20), der zwischen benachbarten Grabenkondensatoren liegt, freigelegt wird.

11. Verfahren nach Anspruch 10,
**dadurch gekennzeichnet, daß**
die erste Maske (5), die zweite Maske (19) und die seitlichen Randstege (18) eine gemeinsame Ätzmaske beim Ätzen eines Isolationsgrabens (21) bilden.
